# EUROPEAN PATENT APPLICATION

(11) **EP 2 997 851 A1**
(43) Date of publication of application: **23.03.2016**
(21) Application number: 15185440.3
(22) Date of filing: 16.09.2015
(51) Int. Cl.: A47B 19/00, H02G 3/00, A47B 21/06, H01R 13/639

(54) **MEDIA CONTROL CONSOLE**

(30) Priority: 19.09.2014 GB 201416629
(71) Applicant: Stage Electrics Partnership Limited, Avonmouth, Bristol BS11 9YL (GB)
(72) Inventor: ALDRIDGE, Dan, Avonmouth, Bristol BS11 9YL (GB); BLAXILL, Adam, Avonmouth, Bristol BS11 9YL (GB); THOMPSON, Richard, Avonmouth, Bristol BS11 9YL (GB); REDMAN, Andrew, Avonmouth, Bristol BS11 9YL (GB); HUNT, Gary, Avonmouth, Bristol BS11 9YL (GB)
(74) Representative: chapman + co

(57) **Abstract**

A media control console is described which comprises a lectern type housing, one or more media electronics modules mounted within the lectern type housing, and an umbilical cable carrying electrical power to the media electronics modules and/or control signals to and/or from the media electronics modules. The umbilical cable is durably attachable or permanently attached to the media control console and a fixed electrical installation external to the console.

## Description

### Field of the invention

The present invention relates to a media control console. Embodiments of the present invention relate to a media control console in a lectern type housing.

### Background to the invention

School drama studios are generally either in the main assembly hall in smaller schools, or more usually in a separate classroom fitted out with sound, video projection and stage lighting equipment. Typically the separate classroom type of studio will include a portable lighting desk stored in a cupboard, which is brought out and plugged into the lighting installation when needed. The studio will also include other media equipment, such as a CD/DVD player, microphone receiver and amplifier. This equipment may be installed in a stand, cabinet, or simply placed down on the nearest desk or shelf. There is a problem that this set up is somewhat ad-hoc, not very easy to organise or adapt for the flexible use of the space required for teaching drama. It is also quite hard to understand and operate for people who are not familiar with technology. Embodiments of the present invention seek to address these problems.

Some alternative solutions to these problems are presented in CN2013490847U, US2008043386A, JP2002099351A, WO2009048333A, US2005239037 and CN201147005Y.

### Summary of the invention

According to an aspect of the present invention, there is provided a mobile media control console, comprising:
a lectern type housing;
one or more media electronics modules mounted within the lectern type housing; and
an umbilical cable carrying electrical power to the media electronics modules and/or control signals to and/or from the media electronics modules, the umbilical cable being durably attachable or permanently attached to the media control console and a fixed electrical installation external to the console.

In this way, it is possible to provide a mobile drama console, which combines all the media players, sound and lighting controls required by, for example a drama teacher, into one easy to understand and operate unit, shaped to look and act as a useful teaching lectern. The durably or permanently attached umbilical cable allows the unit to be moved around the room, but can prevent it being removed from the studio. This is highly beneficial in the relatively unsecure public area of a school or other educational or performance establishment, since the electronics modules provided in the console may be of significant financial value making the console potentially prone to theft. Preferably, the fixed electrical installation is a ceiling, wall or floor installation to which the umbilical cable is durably or permanently attached at one end.

It will be appreciated that the umbilical cable may be provided separately from the console. In this case, the console may be provided with an electrical socket to which the umbilical cable can be attached, the electrical socket comprising a security cover which can be locked or otherwise secured over one end of the umbilical cable when the umbilical cable is engaged with the electric socket, in which state the security cover inhibits removal of the umbilical cable from the media control console. While in general a standard off the shelf cable is adequate to prevent theft of the console, optionally, in order to further reduce the risk of the umbilical being cut to enable the theft of the console, the umbilical cable can be durable, toughened, armoured or reinforced.

Various media electronics modules may be provided, for example one or more of a lighting control module for controlling a lighting installation, a media player for playing media content and outputting the media content to a display device external of the media control console, an amplifier for amplifying and outputting audio signals externally of the media control console, and a radio microphone controller for controlling a radio microphone(s).

Preferably, a top surface of the lectern type housing is slanted down towards the front of the housing, and comprises a front portion which opens to expose a media interface panel permitting a user to interact with the media electronics modules. When closed, the console acts as a traditional lectern with nil or minimal media control, while when open it can be used to provide more extensive media control functionality.

Preferably the media electronics modules are received within a rack mount arranged within the cabinet housing such that a control panel portion of each module is positioned to form part of the media interface panel. This means that from the user's perspective all of the controls are available in a single interface area. As a rack mount system, it will be appreciated that different media electronics modules may be inserted in the rack. For example, different types and classes of amplifier could be used, or a lighting controller may be selected for different lighting installations. To take this into account, the media interface panel may comprise a removable fascia. The fascia may be customized for user requirements, or to match the particular media electronics modules actually present in the rack mount.

Preferably the front portion of the top surface comprises first and second wings each of which are hingedly connected to the lectern type housing and can be pivoted between a closed position in which the first and second wings conceal the media interface panel and an open position in which the first and second wings extend outwardly to each side respectively of the lectern type housing to form additional working surfaces. In this way, the overall area available for the user to place notes or equipment is effectively preserved even when the wings are open. Preferably, a lock is provided for locking the first and second wings in the closed position. This has various benefits, such as making it more difficult to remove the media electronics modules, or enabling media settings (e.g. lighting levels) to be specified and then protected from tampering by locking away the user interface panel from interference. Preferably, a receiving surface for a mobile telephone or other portable electronic device is provided adjacent to the media interface panel in a position where it is concealed by the first and second wings when in the closed position. In this way, the mobile telephone can be left to stream media content to the console while locked away under the wings, reducing the likelihood of theft. The receiving surface may be adjacent a Bluetooth and/orNFC (Near Field Communication) point for permitting communication between the mobile telephone and the media control console. The receiving surface may comprise a tray into which the mobile telephone can be placed.

Preferably, the console comprises a power usage meter operable to indicate a current power consumption of the media control console and/or the external devices being controlled. The power usage meter may monitor the power consumption of each of the media electronics modules, and preferably that of any external devices such as speakers, projectors, display devices and lights. This enables the user to determine the current power consumption of the unit in any given usage state. This feature acts as an aid to energy consciousness whilst also permitting users to correlate the difference in power use between varying types of usage of the media equipment. For example, the user will quickly learn which items of equipment (e.g. lights, projector etc.) use a significant amount of power, and will be encouraged to power down these items of equipment when they are not required, rather than simply leaving them running.

Preferably, each of the wings is wedge shaped such that the additional working surface provided by the wings when in the open position is at a shallower angle than the top surface of the wings when in the closed position. A rear portion of the top surface of the lectern type housing is preferably dimensioned to receive a laptop computer. Preferably, a front edge of the rear portion of the top surface comprises a flip-up or pop-up ledge for retaining a laptop or other item, which might otherwise slide down the sloped upper surface of the lectern.

Preferably, a rear or side portion of the top surface of the lectern type housing comprises a connector box having a lid, the connector box containing one or more cable end connectors of cables which extend into the interior of the lectern type housing, wherein when the lid of the connector box is closed, it can only be opened when the front portion of the top surface of the lectern is open. Again, this ensures that the cables are kept secure. However, in order to enable the cables to be usable when the lectern is closed, the connector box preferably comprises one or more cable guides through which the one or more cables can extend to the outside of the media control console when the connector box is in its closed position.

Preferably, a retractable surface is provided which extends to the front of the console from a position underneath the media interface panel, the retractable surface being stowed within the lectern type housing in a folded state and being unfoldable to form a larger surface area once outside of the housing.

Preferably, the console comprises a lockable storage area. This may be a large area within the stand portion of the lectern. The lectern type housing may comprise an upper part containing the media electronics modules, a central part providing storage, and a lower base part housing caster wheels, wherein the upper and lower parts extend further forwards than the central part to provide an ergonomic cutaway in the central part. The ergonomic cutaway enables a seated user to sit closer to the lectern to access the controls, while the relatively larger base part provides a step on which the user can place his feet, while providing a larger wheel base for the casters to improve stability.

Preferably, an internal bulkhead is provided within the lectern type housing for separating wiring associated with the media electronics modules from a user's cables.

### Detailed description

The invention will now be described by way of example with reference to the following Figures in which:
Figure 1 schematically illustrates a view of the top, front and side of a multimedia console in a closed configuration;
Figure 2 schematically illustrates a view of the top, rear and side of the multimedia console of Figure 1;
Figure 3 schematically illustrates a view of the top, front and side of the multimedia console in an open configuration;
Figure 4 schematically illustrates a cross sectional view of the multimedia console in an open configuration; and
Figure 5 schematically illustrates in close-up a lay-out of features and components of the multimedia console.

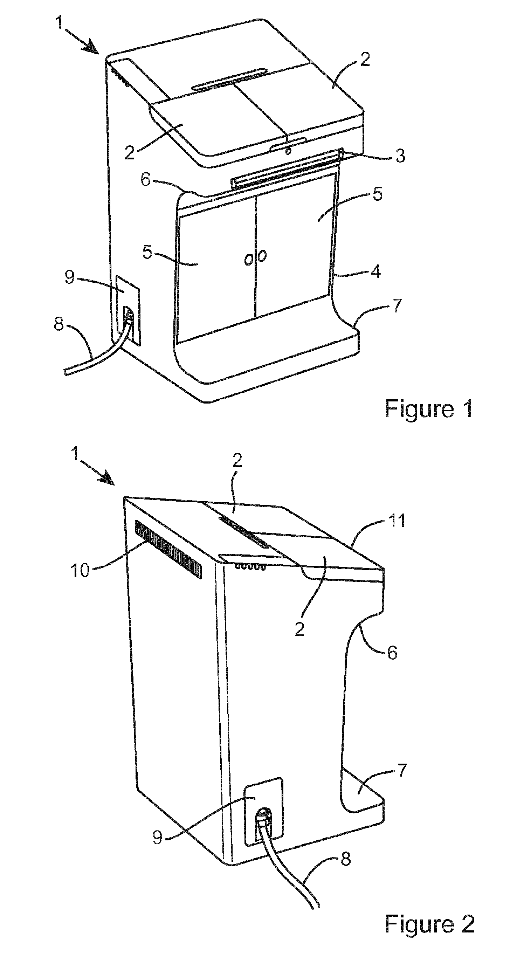

A combined lighting, sound and multimedia teaching hub or media control console is described herein, and is housed in a mobile lectern style cabinet on wheels. Referring to Figure 1, a view of the top, front and side of the multimedia console 1 in a closed configuration is shown. The media console 1 has on its lectern style top face two lockable doors 2, behind which is the main user interface control panel (not visible in Figure 1) of the console 1. The doors 2 may be hinged at each side of the lectern and open out sideways away from each other to form useful workspaces for books or other equipment (as will be described below). The media console 1 also comprises a table drawer 3, which in Figure 1 is shown in a stowed position, and a storage cabinet 4 with two lockable doors 5. In addition, the media console 1 comprises a "cutaway" portion 6 and a "step" 7. The cutaway portion 6 provides space for the knees of a seated user of the console 1 and the step 7 provides a platform on which the user's feet can rest. As a mobile unit, the console is provided with wheels or casters underneath the base. The step 7 increases the footprint of the base. The front wheels are located underneath the step 7. As a result, the stability of the media console 1 is improved due to the increase in size of the wheel base, reducing the likelihood of it toppling over when it is moved around a room. A strong umbilical cable 8, which if necessary (dependent on application) may be durable, armoured, reinforced or toughened, is attached to the media console 1. The umbilical cable 8 provides power and to the console 1 and data connectivity between the console 1 and external devices (e.g. speakers, display screens, video projector, lighting). The control system umbilical cable 8 therefore provides power, audio, video and lighting control to operate the lights, video projector and speakers for example. The umbilical cable 8 may itself contain smaller cables (power and data lines) within an armoured or toughened surround. The umbilical cable 8 allows the console 1 to be moved around a room while preventing the console 1 from being removed from the room. The umbilical cable 8 may be provided with high visibility or reflective markings or a bright colour scheme in order to reduce the trip hazard associated with it. The attachment of the umbilical cable 8 to the console 1 (for example via a plug and socket arrangement) is behind a plate 9 (security cover), which can be either lockable, or secured in place using anti-tamper fixings, which prevents easy or unwanted detachment of the umbilical cable 8. The other end of the umbilical cable 8 is permanently or securely fixed to a wall or floor based electrical installation in the room/studio where the control console 1 is located. As a result, the console 1 is permanently or durably attached to an electrical wall or floor installation by an umbilical cable, allowing free movement around the studio, whilst preventing it being removed from the room. It will therefore be appreciated that the console sits on casters and is thus mobile, and yet is connected to the lighting, speakers and electricity via a strong cable umbilical, permanently wired into or durably connected to a distribution box mounted on the wall. This permits adequate mobility to reposition the console within the room according to need, but preventing or at least inhibiting its removal from the room.

The umbilical could optionally be re-routed vertically in order to keep it off the floor and then connect vertically to a sliding track arrangement on the ceiling or the lighting rig. This would utilize a number of cable loops hanging on track sliders, allowing it to have lots of extension. In order to achieve this, the cable could run vertically up the unit from its point of connection, to emerge from the top (possibly either internally, inside a half buried duct covered by an external strip on the back or side of the unit, or simply pinned or clipped onto the outside).

Referring to Figure 2, a view of the top, front and side of the multimedia console 1 in a closed configuration is shown. Additional features shown in Figure 2 beyond those also shown in Figure 1 include a vent 10 on the rear of the console 1 (which might be formed in the shape of a logo) and a retaining lip 11 at the front upper edge (when in closed position) of the two doors 2 on the top of the console 1. This retaining lip is useful for preventing books, pens etc. from falling from the lectern.

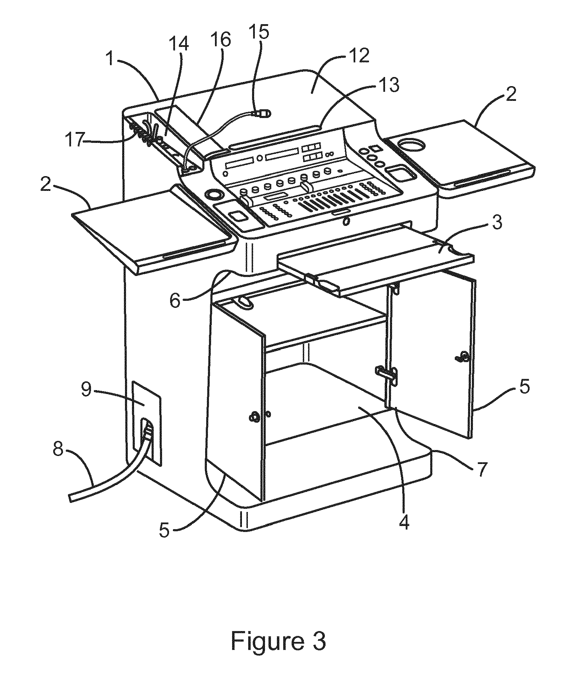

Referring to Figure 3, a view of the top, front and side of the media console 1 in the open configuration is shown. In Figure 3, it can be seen that the lectern style top opens with two sideways opening (e.g. hinged) doors to reveal the central equipment interface area (user interface control panel) laid out ergonomically. The revealed interface provides controls for (for example) a lighting desk, microphone receiver, amplifier and CD/DVD player in a sloped stack from front to back. Other studio electrical components could also be provided. Internally of the lectern type casing, a "rack-mount" arrangement is provided, allowing the manufacturer flexibility to choose equipment layout. The rack mount is arranged such that control panels from the media electronics modules are positioned and oriented appropriately at the central equipment interface. This interface area includes a thin cover panel (fascia) over the front of the equipment modules, integrating these into one simplified user interface which can be printed on to customize the labels and instructions.

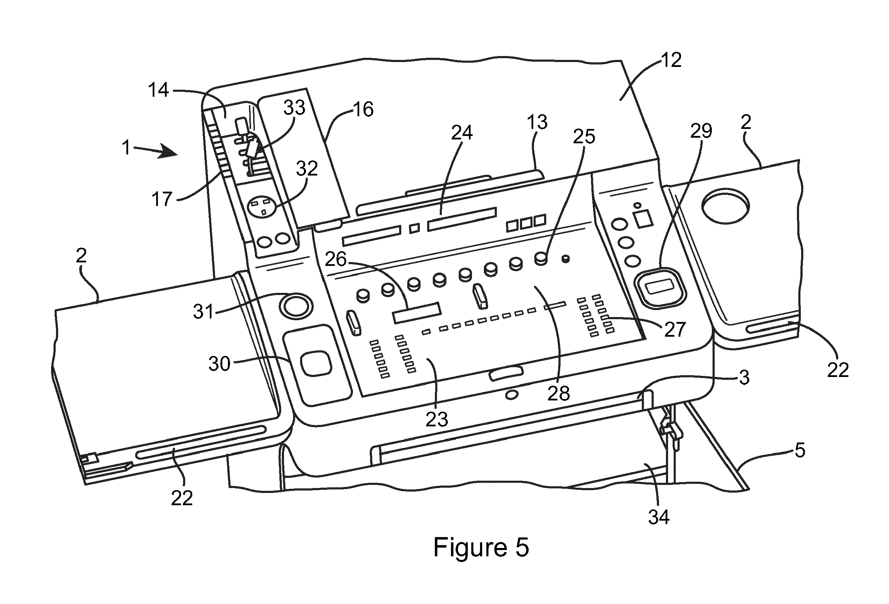

As discussed above, the opened doors 2 form wings which provide further workspaces for putting books and other equipment. At least part of the doors 2 are wedge-shaped (thinner towards the rear than towards the front), or otherwise angled such that the slope of the upper surface of the wings in the open position is shallower than the slope of the upper surface of the wings in the closed position. As a result, papers and other materials are less likely to slide off. Additionally, greater clearance is provided for items within the compartment formed underneath the doors 2 when they are in the closed position. Another workspace 12 is also provided on a rear part of the top of the console 1. This workspace 12 is suitable for placing teaching materials or a laptop, and the front edge of this workspace comprises a flip up ledge 13 to retain the teaching materials or laptop in position. The table drawer 3 is in Figure 3 shown to be in an extended and folded out position and provides an optional extra workspace suitable, in particular, for scripts or other materials. The mechanism which allows the table drawer 3 to fold out may be similar to the mechanism used for airplane seat back tables. The storage cabinet 4 is shown open and provides a substantial area of storage, including a shelf 34, suitable for storing teaching materials or any personal possessions of the user. In addition, Figure 5 shows a connector box 14 which houses the most frequently used connectors, such as that used for a microphone 15. The connector box 14 can be shut and locked when required by means of a lid 16. A tab on the lid 16 or the adjacent door 2 enables the lid 16 to be locked shut when the doors 2 are closed. Cable guides 17 on the side of the connector box 14 allow cables to enter and leave the connector box 14 when it is shut (in lectern mode).

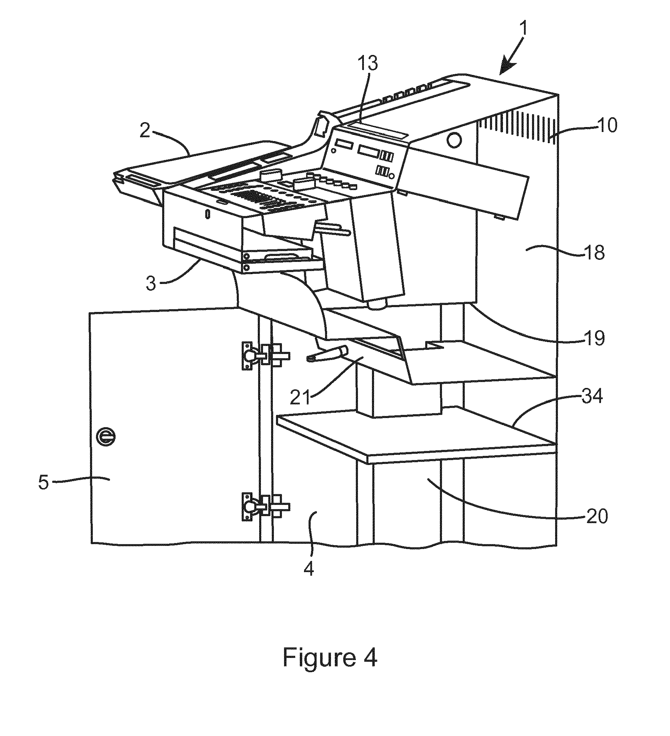

Referring to Figure 4, a cross sectional view of the media console 1 is shown. Additional features of the invention shown in Figure 4 beyond those mentioned above include an internal space 18 for the wiring of the multimedia console components, a bulkhead 19 to separate the user's cables from the main wiring of all the electrical components and ducting 20 for the umbilical cable 8. In addition, Figure 4 shows a rack 21 with additional connectors, which can be accessed through the doors of the cabinet 4. The additional connectors could include lesser used cable connections that might be used by more experienced users for more specialist applications, for example, offering ability to connect other devices to control the lighting through a DMX connector - thereby offering greater functionality, but keeping the main interface simple for the majority of users.

Referring to Figure 5, a view of the top of the media console 1 of the present invention is shown, with particular focus on the central interface area and the connector box 14. The surface of the opened wing doors 2 include channels 22 which function as a pen tray. The main control panel 23 is shown to comprise a DVD player 24, an amplifier control 25, a radio microphone control 26, a lighting desk 27 and a spare panel 28. Also visible is an energy monitor 29, NFC point 30 and a microphone holder 31. The energy monitor 29 is able to monitor the current power consumption of the console (including that of all media electrical modules) and that of external devices (such as speakers, projectors, display screens or lights), and display the total power output (and optionally the power output of each or some of the separate components individually). In addition, Figure 5 shows inside the connector box 14 which comprises a mains plug socket 32, further connectors, and a cable comb 33 that retains cables in a position ready for use. A single master on-off switch is provided, enabling all equipment to be switched on and off with a single action. The NFC point may be part of or adjacent to a receiving surface and/or tray for a mobile telephone or other portable electronic device. It will be appreciated that the mobile telephone, when placed in a tray at this position, will be concealed by the wing doors when they are in the closed position, meaning that the mobile telephone can be secured within the lectern while (for example) streaming music, video or other data to the media console 1.

The media controller as described above provides a number of benefits over existing media controllers. For example, the combining of multiple controls into a single interface on a lectern makes the device easy to use, and the removable fascia enables customizable graphics, labels & instructions to be provided to simplify operation further. The media controller also provides the following advantages:
- Much better for storage and suitable for the studio environment.
- More secure, due to umbilical, and the ability to lock away electronics, mobile devices etc. while still in use.
- More convenient for connections/cables etc. - no need to hunt around.
- Provides more suitable platform for teaching, even when using in its closed up state as a lectern.
- It is possible to have lighting pre-set to a level then the controller be locked by securing the wing doors over the user interface - for example when other groups are using the room.
- Reduced risk of injury in the event a child/adult bumps into the unit as a result of extensive use of rounded edges in the design.
- Supports Bluetooth and NFC connection of multimedia devices as well as more traditional cable based connections.
- Extensible system supports the connection of external audio mixing console and/or lighting console when increased number of inputs or control are required.
- Incorporates power consumption metering enabling greater user awareness of the correlation between their actions and the associated power usage.
- High visibility/contrast umbilical cable reduces trip hazard risk.

## Claims

1. A mobile media control console, comprising:
a lectern type housing;
one or more media electronics modules mounted within the lectern type housing; and
an umbilical cable carrying electrical power to the media electronics modules and/or control signals to and/or from the media electronics modules, the umbilical cable being durably attachable or permanently attached to the media control console and a fixed electrical installation external to the console.

2. A mobile media control console according to claim 1, wherein the fixed electrical installation is a ceiling, wall or floor installation to which the umbilical cable is durably or permanently attached at one end.

3. A mobile media control console according to any preceding claim, comprising an electrical socket to which an umbilical cable carrying electrical power to the media control console and/or control signals to and/or from the media control console can be attached, the electrical socket comprising a security cover which can be locked or otherwise secured over one end of the umbilical cable when the umbilical cable is engaged with the electric socket, in which state the security cover inhibits removal of the umbilical cable from the media control console.

4. A mobile media control console according to any preceding claim, wherein the umbilical cable is durable, toughened, armoured or reinforced.

5. A mobile media control console according to any preceding claim, in which the media electronics modules comprise one or more of a lighting control module for controlling a lighting installation, a media player for playing media content and outputting the media content to a display device external of the media control console, an amplifier for amplifying and outputting audio signals externally of the media control console, and a radio microphone controller for controlling a radio microphone.

6. A mobile media control console according to any preceding claim, wherein a top surface of the lectern type housing is slanted down towards the front of the housing, and comprises a front portion which opens to expose a media interface panel permitting a user to interact with the media electronics modules.

7. A mobile media control console according to claim 6, wherein the media electronics modules are received within a rack mount arranged within the cabinet housing such that a control panel portion of each module is positioned to form part of the media interface panel.

8. A mobile media control console according to claim 6, wherein the front portion of the top surface comprises first and second wings each of which are hingedly connected to the lectern type housing and can be pivoted between a closed position in which the first and second wings conceal the media interface panel and an open position in which the first and second wings extend outwardly to each side respectively of the lectern type housing to form additional working surfaces.

9. A mobile media control console according to claim 8, wherein each of the wings is wedge shaped such that the additional working surface provided by the wings when in the open position is at a shallower angle than the top surface of the wings when in the closed position.

10. A mobile media control console according to claim 8 or 9, wherein a receiving surface for a mobile telephone or other portable electronic device is provided adjacent to the media interface panel in a position where it is concealed by the first and second wings when in the closed position.

11. A mobile media control consoles according to claim 10, wherein the receiving surface is adjacent a Bluetoooth and/or NFC (Near Field Communication) point for permitting communication between the mobile telephone and the media control console.

12. A mobile media control console according to claim 6, wherein a rear portion of the top surface of the lectern type housing comprises a connector box having a lid, the connector box containing one or more cable end connectors of cables which extend into the interior of the lectern type housing, wherein when the lid of the connector box is closed, it can only be opened when the front portion of the top surface of the lectern is open.

13. A mobile media control console according to claim 12, wherein the connector box comprises one or more cable guides through which the one or more cables can extend to the outside of the media control console when the connector box is in its closed position.

14. A mobile media control console according to any preceding claim, wherein the lectern type housing comprises an upper part containing the media electronics modules, a central part providing storage, and a lower base part housing caster wheels, wherein the upper and lower parts extend further forwards than the central part to provide an ergonomic cutaway in the central part.

15. A mobile media control console according to any preceding claim, comprising a power usage meter operable to indicate a current power consumption of the media control console and/or any external devices being controlled.
